Europäisches Patentamt

European Patent Office

Office européen des brevets

(11) Numéro de publication: **0 135 408**
**A1**

(12) # DEMANDE DE BREVET EUROPEEN

(21) Numéro de dépôt: 84401459.7

(22) Date de dépôt: 10.07.84

(51) Int. Cl.⁴: **H 01 L 21/00**
**H 01 L 21/225, H 01 L 21/60**
**H 01 L 29/40**

(30) Priorité: 13.07.83 FR 8311737

(43) Date de publication de la demande:
27.03.85 Bulletin 85/13

(84) Etats contractants désignés:
DE FR GB IT NL

(71) Demandeur: **LE SILICIUM SEMICONDUCTEUR SSC**
**101, Boulevard Murat**
**F-75016 Paris(FR)**

(72) Inventeur: **Coello-Vera, Agustin**
**THOMSON-CSF SCPI 173, bld Haussmann**
**F-75379 Paris Cedex 08(FR)**

(74) Mandataire: **Guérin, Michel et al,**
**THOMSON-CSF SCPI 173, Bld Haussmann**
**F-75379 Paris Cédex 08(FR)**

(54) Transistor bipolaire haute fréquence et son procédé de fabrication.

(57) Ce transistor comprend au-dessus des doigts de base (10) une couche de siliciure de titane à partir de laquelle ont été formées les diffusions de base (10) et une couche de nitrure de silicium (4). Les bords des sandwiches constitués par les bandes (3) et (4) sont bordés par un remblai (7) de silice formé automatiquement par dépôt et attaque aniso-trope sans masquage supplémentaire. Les doigts d'émetteur (9) sont surplombés par une couche de silicium polycristallin (8) à partir duquel le dopage de ces doigts a été obtenu.

On obtient ainsi automatiquement et sans alignement de masques la possibilité d'avoir des doigts d'émetteur et de base fortement rapprochés avec des distances de garde minimales.

Fig.5

## TRANSISTOR BIPOLAIRE HAUTE FREQUENCE ET SON PROCEDE DE FABRICATION.

La présente invention concerne un transistor bipolaire haute fréquence, c'est-à-dire par exemple destiné à fonctionner à des fréquences supérieures à la centaine de mégahertz, et un procédé de fabrication d'un tel transistor.

De façon générale, des transistors bipolaires destinés à fonctionner à haute fréquence comprennent sur l'une de leurs faces principales un contact de collecteur et sur l'autre face principale des zones d'émetteur et de base constituées par exemple de doigts parallèles et alternés. Pour améliorer les caractéristiques de fonctionnement de tels transistors, il est souhaitable que ces doigts soient aussi étroits et aussi proches que possible. Pour un transistor de surface donnée, ceci permet de le faire fonctionner à plus haute fréquence ou, pour un transistor fonctionnant à fréquence donnée, ceci permet d'augmenter la puissance de fonctionnement et de réduire les caractéristiques de bruit.

La présente invention prévoit une nouvelle structure de transistor bipolaire et un procédé de fabrication d'un tel transistor permettant de minimiser la largeur des doigts d'émetteur et de base et de réduire à une valeur très faible la distance entre un doigt d'émetteur et un doigt de base. Selon ce procédé, on évite d'effectuer des alignements successifs de masques pour définir les doigts de base et les doigts d'émetteur et donc l'intervalle entre eux ; au contraire les dimensions et les configurations des doigts d'émetteur et de base sont déterminées à l'aide d'un masquage initial unique, ce qui évite de nécessiter la prévision de tolérance de positionnement pour l'alignement de masques successifs.

Un transistor selon la présente invention comprend à la surface d'une tranche semiconductrice des zones alternées de types de conductivité distincts formant les doigts de base et les doigts d'émetteur. Les doigts de base sont revêtus d'un sandwich comprenant au moins une première couche conductrice constituée d'un

2

siliciure métallique et d'une deuxième couche isolante ; des remblais isolants s'appuient sur les parois latérales de ces sandwiches et s'étendent de façon à recouvrir les limites des doigts de base et d'émetteur ; et les doigts d'émetteur sont revêtus d'au moins une couche conductrice débordant sur la deuxième couche isolante.

Un procédé de fabrication d'un transistor selon l'invention consiste à : former sur un substrat de silicium d'un premier type de conductivité une première couche d'un siliciure métallique dopé par un dopant d'un premier type de conductivité ; déposer une deuxième couche d'une première substance isolante ; ouvrir les première et deuxième couches pour laisser en place un réseau de bandes parallèles ; déposer uniformément une troisième couche d'une deuxième substance isolante ; attaquer de façon anisotrope la troisième couche de sorte que ses parties planes sont éliminées, mais que des remblais demeurent en place contre les bords des bandes constituées par les première et deuxième couches ; et procéder à une étape de dopage, d'une part, à partir des ouvertures entre lesdites bandes selon un deuxième type de conductivité pour former des zones d'émetteur, d'autre part, par diffusion du dopant contenu dans le siliciure pour former des zones de contact et de base. Le siliciure peut être un siliciure de titane ; la première substance isolante peut être du nitrure de silicium et la deuxième substance isolante de l'oxyde de silicium.

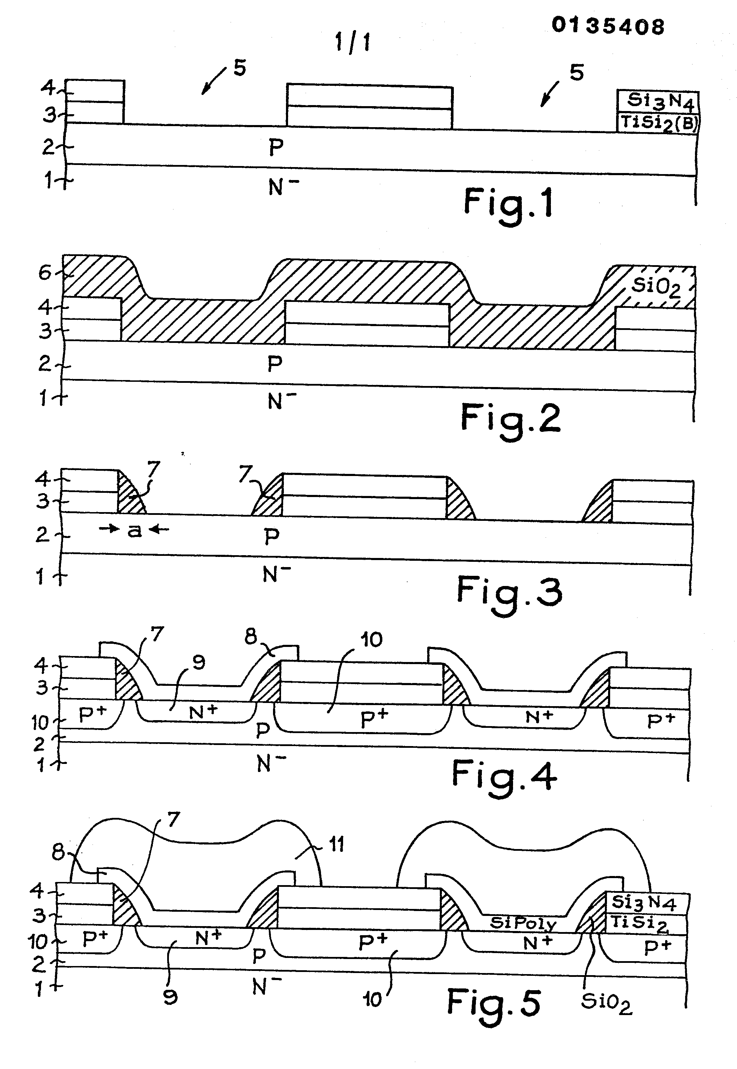

Ces objets, caractéristiques et avantages ainsi que d'autres de la présente invention seront exposés plus en détail dans la description suivante d'un mode de réalisation particulier faite en relation avec les figures 1 à 5 ci-jointes qui illustrent des étapes successives de fabrication d'un transistor selon l'invention.

Il est clair que, dans ces diverses figures, aucune des dimensions n'est représentée à l'échelle conformément à l'usage dans la représentation des semiconducteurs.

La structure de départ, pour fabriquer un transistor selon la présente invention, est une tranche de semiconducteur, par exemple du silicium, comprenant des couches successives dopées de type $N^+$ (non représentée), de type $N^-$ et de type P. Les couches $N^-$ et $N^+$ correspondent à la couche de collecteur et de prise de contact de collecteur, une métallisation de collecteur étant déposée sur la couche $N^+$. La couche 1 de type $N^-$ est par exemple formée par épitaxie sur un substrat de type $N^+$ et la couche 2 de type P est par exemple formée par diffusion ou par implantation ionique et redistribution ou encore par épitaxie.

Sur la surface de la couche 2 de type P, comme le représente la figure 1, on dépose successivement une couche 3 d'un siliciure métallique et une couche 4 d'un matériau isolant. La couche de siliciure métallique 3 est fortement dopée avec un produit dopant de type P, par exemple du bore. Ce peut être une couche de siliciure de titane $TiSi_2$ ou de siliciure de tungstène $WSi_2$. Son épaisseur est par exemple de 2000 à 3000 angstroems. Elle peut être formée de diverses manières, par exemple par pulvérisation simultanée de silicium et du métal ou par évaporation par faisceau électronique. Une caractéristique importante de cette couche réside dans sa faible résistivité.

La couche isolante 4 est par exemple une couche de nitrure de silicium. Elle peut avoir une épaisseur de l'ordre de 2 000 angstroems.

Après cela, on ouvre dans l'ensemble des deux couches 3 et 4 des bandes 5, sensiblement aux emplacements où l'on souhaite former les doigts d'émetteur. Cette ouverture peut se faire par tout procédé classique, par exemple par masquage par contact sous vide suivi d'une gravure sous plasma.

Comme le représente la figure 2, on dépose ensuite une couche uniforme d'une deuxième substance isolante 6, par exemple de l'oxyde de silicium. Ce dépôt peut être effectué en phase vapeur à basse pression et à une température pas trop élevée. L'épaisseur de cette couche sera choisie en fonction d'impératifs qui apparaîtront ci-après.

Dans l'étape illustrée en figure 3, on procède à une attaque anisotrope par un plasma d'ions réactifs ou par une machine de meulage ionique de la couche de silice 6. Le résultat de cette attaque est d'éliminer complètement la couche de silice

là où elle est sensiblement plane, mais de maintenir des remblais de silice 7 aux limites des bandes constituées de la superposition des portions de couches 3 et 4. La largeur à la base a de ces remblais dépend essentiellement de l'épaisseur de la couche d'oxyde 6. Cette épaisseur sera donc choisie, en considérant également le mode d'attaque, pour obtenir une largeur a des remblais satisfaisante pour éviter, comme on le verra ci-après, tout contact entre les zones d'émetteur et les zones de contact de base.

Après cela, comme le représente la figure 4, on dépose sur la surface de la tranche une couche 8 de silicium polycristallin fortement dopé de type N et l'on chauffe la tranche pour faire diffuser dans le substrat, d'une part, les atomes de dopant de type N contenus dans la couche de silicium polycristallin 8 de façon à former des doigts d'émetteur, d'autre part, les atomes de dopant de type P, par exemple du bore, contenus dans la couche de siliciure métallique 3. La largeur a du remblai isolant 7 est choisie de sorte que les doigts d'émetteur 9 et les doigts de contact de base 10 ne se rejoignent pas par suite de cette étape de diffusion.

Enfin, comme le représente la figure 5, dans le cas général où chaque doigt d'émetteur doit être connecté par l'intermédiaire d'une résistance dite de ballast, on peut déposer sur la couche de silicium polycristallin 8 une couche métallique 11 de prise de contact. D'autre part, dans les cas où la résistance de ballast est verticale ou même dans les cas où il n'y a pas de résistance de ballast, la couche métallique de prise de contact d'émetteur pourrait former un continuum au lieu d'être digitée comme en figure 5. Les contacts métalliques à la région de base 2 sont pris sur les bandes de siliciure de titane de chaque côté de cette région 2.

Dans les figures 4 et 5, on a représenté les couches de silicium polycristallin 8 et de prise de contact 11 comme découpées en forme de bandes pour épouser sensiblement l'allure des doigts d'émetteur. On notera que les masquages qui permettent ces découpes ne sont pas sujets à des positionnements critiques car les couches 8 et 11 peuvent plus ou moins déborder au-dessus des bandes de nitrure de silicium 4.

D'autre part, ces couches de silicium polycristallin 8 et de reprise de contact 11 ne sont pas nécessairement découpées en forme de bande selon les profils des doigts d'émetteur, mais peuvent reposer uniformément sur la surface de la tranche puisqu'elles se trouvent être isolées des zones de contact de grille 3 et 10 par la couche de nitrure de silicium 4.

Selon une variante de la présente invention, on pourra aussi réaliser les doigts d'émetteur par une diffusion autre qu'une diffusion à partir d'une couche de silicium polycristallin. On peut prévoir, par exemple, une diffusion en phase gazeuse classique ou une implantation bien que le procédé décrit consistant à utiliser du silicium polycristallin soit aujourd'hui préféré.

Un avantage important du procédé selon la présente invention, tel qu'il a été exposé précédemment, résulte du fait qu'une seule étape critique de masquage illustrée en figure 1 apparaît dans tout le procédé et qu'il n'est pas nécessaire en conséquence de prévoir des zones de garde importantes entre les doigts d'émetteur et les doigts de base. On peut ainsi, pour une technique de gravure donnée, permettant par exemple dans l'étape de la figure 1 de prévoir des bandes d'une largeur de deux microns espacées d'une distance de deux microns, obtenir une densité d'intégration sensiblement deux fois supérieure à celle qui est obtenue par les procédés classiques prévoyant des alignements de masques successifs.

REVENDICATIONS.

1. Transistor bipolaire haute fréquence comprenant à la surface d'une tranche semiconductrice, des zones alternées de types de conductivité distincts formant des doigts de base et des doigts d'émetteur, caractérisé en ce que :

- les doigts de base (10) sont revêtus d'un sandwich comprenant au moins une première bande conductrice (3) constituée d'un siliciure métallique et d'une deuxième bande isolante (4),

- des remblais isolants (7) s'appuient sur les parois latérales desdits sandwiches et s'étendent de façon à recouvrir les limites des doigts de base et d'émetteur,

- les doigts d'émetteur (9) sont revêtus d'au moins une couche conductrice (8, 11) débordant sur les deuxièmes bandes isolantes (4) adjacentes.

2. Transistor bipolaire selon la revendication 1, caractérisé en ce que les deuxièmes bandes isolantes sont en nitrure de silicium et les remblais isolants en silice.

3. Procédé de fabrication d'un transistor bipolaire haute fréquence, caractérisé en ce qu'il comprend les étapes suivantes :

- former sur un substrat de silicium (2) d'un premier type de conductivité une première couche d'un siliciure métallique (3) fortement dopé du premier type de conductivité,

- déposer une deuxième couche d'une première substance isolante (4),

- ouvrir les première et deuxième couches isolantes pour laisser en place des bandes parallèles,

- déposer uniformément une troisième couche (6) d'une deuxième substance isolante,

- attaquer de façon anisotrope la troisième couche de sorte que ses parties planes sont éliminées, mais que des remblais (7) demeurent en place contre les bords des bandes constitués par les première et deuxième couches,

- procéder à une étape de dopage, d'une part, à partir des ouvertures (5) entre lesdites bandes selon un deuxième type de conductivité pour former les zones d'émetteur, d'autre part, par diffusion du dopant contenu dans le siliciure (3) pour former des zones de contact de base (10).

4. Procédé selon la revendication 3, caractérisé en ce que, après la formation des remblais isolants, il comprend l'étape consistant à déposer une couche de silicium polycristallin dopé selon le second type de conductivité pour former ensuite par diffusion les doigts d'émetteur.

5. Procédé selon la revendication 3, caractérisé en ce que le siliciure métallique est un siliciure de titane.

6. Procédé selon la revendication 3, caractérisé en ce que la première substance isolante est du nitrure de silicium et la deuxième substance isolante de la silice.

Fig.1

Fig.2

Fig.3

Fig.4

Fig.5

Office européen
des brevets

**RAPPORT DE RECHERCHE EUROPEENNE**

**0135408**
Numéro de la demande

EP   84 40 1459

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| Y | EP-A-0 076 105  (FUJITSU LTD.) <br> * Page 7, ligne 3 - page 9, ligne 7; figures 10-15 * | 1-4 | H 01 L   21/00 <br> H 01 L   21/225 <br> H 01 L   21/60 <br> H 01 L   29/40 |
| | --- | | |
| Y | EP-A-0 051 500  (FUJITSU LTD.) <br> * Page 8, ligne 13 - page 11, ligne 6; figures 3,4; revendications 1,2 * | 1-5 | |
| | --- | | |
| A | US-A-4 381 953  (A.P. HO et al.) <br> * Résumé; figures 14-17 * | 1 | |
| | --- | | |
| A | IBM TECHNICAL DISCLOSURE BULLETIN, vol. 25, no. 4, septembre 1982, pages 1887-1889, New York, USA; C.G. JAMBOTKAR: "Using a doubly implanted polysilicon layer for forming base and emitter regions" <br> * Page 1889, alinéa 2; figure 2 * | 1 | **DOMAINES TECHNIQUES RECHERCHES (Int. Cl.4)** <br><br> H 01 L |
| | --- | | |
| A | IBM TECHNICAL DISCLOSURE BULLETIN, vol. 23, no. 5, octobre 1980, pages 1917-1918, New York, USA; N.G. ANANTHA et al.: "High voltage power transistor method" <br> * En entier * | 1 | |
| | ----- | | |

Le présent rapport de recherche a été établi pour toutes les revendications

| Lieu de la recherche | Date d'achèvement de la recherche | Examinateur |
|---|---|---|
| LA HAYE | 29-10-1984 | PELSERS L. |